Europäisches Patentamt

European Patent Office

Office européen des brevets

(19)

(11) Veröffentlichungsnummer : **0 340 513 B1**

# (12) EUROPÄISCHE PATENTSCHRIFT

(45) Veröffentlichungstag der Patentschrift :
**05.08.92 Patentblatt 92/32**

(51) Int. Cl.⁵ : **C23C 18/20**

(21) Anmeldenummer : **89106827.2**

(22) Anmeldetag : **17.04.89**

(54) **Verfahren zum Metallisieren von Substratoberflächen.**

Die Akte enthält technische Angaben, die nach dem Eingang der Anmeldung eingereicht wurden und die nicht in dieserPatentschrift enthalten sind.

(30) Priorität : **29.04.88 DE 3814506**

(43) Veröffentlichungstag der Anmeldung :
**08.11.89 Patentblatt 89/45**

(45) Bekanntmachung des Hinweises auf die Patenterteilung :
**05.08.92 Patentblatt 92/32**

(84) Benannte Vertragsstaaten :
**BE CH DE FR GB IT LI NL SE**

(56) Entgegenhaltungen :
**DE-A- 2 443 488**
**FR-A- 2 437 451**
**US-A- 4 578 310**
**Römpps Chemie-LexikonBand 1, 8. Auflage, 1985, Seiten 64-65**
**Römpps Chemie-Lexikon, Band 4, 8. Auflage, 1985, Seiten 2866-2867**
**Polymer Handbook, zweite Auflage, 1975, John Wiley & Sons, Seite III-224**
**G. Stipan, Zur Haftung von Lacken auf Kunststoffoberflächen, Seiten 57, 59 und 170; Dissertation Dezember 1989, UniversitätStuttgart**

(73) Patentinhaber : **BAYER AG**
**W-5090 Leverkusen 1 Bayerwerk (DE)**
Patentinhaber : **MOBAY CORPORATION**
**Mobay Road**
**Pittsburgh Pennsylvania 15205-9741 (US)**

(72) Erfinder : **Sirinyan, Kirkor, Dr.**
**Humperdinckstrasse 12**
**W-5060 Bergisch Gladbach 2 (DE)**
Erfinder : **Dederichs, Reinhold**
**Kurt-Schumacher-Ring 86**
**W-5090 Leverkusen 1 (DE)**
Erfinder : **Merten, Rudolf, Dr.**
**Berta-von-Suttner-Strasse 55**
**W-5090 Leverkusen 1 (DE)**
Erfinder : **Gizycki, Ulrich, Dr.**
**Wiembachallee 24**
**W-5090 Leverkusen 3 (DE)**
Erfinder : **Wolf, Gerhard-Dieter, Dr.**
**Wilhelm-Busch-Strasse 29**
**W-4047 Dormagen 5 (DE)**
Erfinder : **Williams, John Lewis, Dr.**
**Nietzschestrasse 12**
**W-5090 Leverkusen 1 (DE)**

(74) Vertreter : **Gremm, Joachim, Dr. et al**
**Bayer AG Konzernverwaltung RP Patente Konzern**
**W-5090 Leverkusen 1, Bayerwerk (DE)**

EP 0 340 513 B1

**Beschreibung**

Es ist bekannt, daß polymere Werkstoffe vor dem chemischen und dem nachfolgenden galvanischen Metallisieren vorbehandelt werden müssen, z.B. durch Ätzen der Polymeroberfläche mit Chromschwefelsäuren.

Bei der Ätzung wird die Polymeroberfläche so verändert, daß es zur Bildung von Kavernen und Vakuolen kommt. Dies ist nur bei bestimmten Polymeren möglich z.B. bei 2-Phasen-Mehrkomponenten-Pfropf- oder Copolymerisaten, wie ABS-Polymerisaten, schlagfestem Polystyrol oder 2-Phasen-Homopolymerisaten, wie teilkristallinem Polypropylen.

Weiterhin ist das Arbeiten mit Chromschwefelsäure oder anderen Oxidantien mit einer Verschlechterung der physikalischen Eigenschaften, wie Kerbschlagzähigkeit und des elektrischen Oberflächenwiderstands des polymeren Basismaterials, verbunden.

Darüber hinaus führt das in das Aktivierungs- und Metallisierungsbad eingeschleppte sechswertige Chrom zu einer Vergiftung der Bäder.

Die gleichen Nachteile stellen sich bei Verfahren ein, bei denen die Polymeroberflächen mittels eines starken gasförmigen Oxidationsmittels, z.B. heißem $SO_3$-Dampf chemisch verändert werden.

Die bekannten Verfahren zur stromlosen Metallisierung von Werkstoffen bestehen im übrigen aus verhältnismäßig vielen Verfahrensstufen und haben zudem den Nachteil, daß sie auf Substrate beschränkt sind, die wegen ihrer physikalischen Beschaffenheit oder des chemischen Aufbaues eine chemische oder physikalische Aufrauhung ermöglichen.

Aus EP-A 0 081 129 ist weiterhin bekannt, daß eine Aktivierung, die durch "quellende Haftbekeimung" erzielt wird, zu gut haftenden Metallauflagen führt. Dieses elegante Verfahren hat jedoch den Nachteil, daß es bei kompliziert geformten Polymer-Spritzgußteilen zur Spannungsrißbildung führt. Ferner erfordert dieses Verfahren für jede Kunststoffart ein neues Quellaktivierungssystem und ist somit nicht universell anwendbar.

Schließlich sind aus US-A 3 560 257 und 4 017 265 sowie DE-A 3 627 256 Verfahren zur Aktivierung bekannt, die haftvermittelnde Polymere enthaltende Aktivatorlösungen verwenden. Der Nachteil dieser Verfahren besteht darin, daß sie den Einsatz relativ großer Mengen an den teueren Edelmetallaktivatoren erfordern.

Aufgabe der vorliegenden Erfindung war daher, die Entwicklung eines preiswerten Verfahrens zur chemischen Metallisierung, mit der ohne vorheriges Ätzen mit Oxidantien Werkstoffoberflächen auf der Basis von allen gängigen Kunststoffen, mit einem gut haftendend auf naßchemischem Weg abgeschiedenen Metallüberzug zu versehen.

Die Aufgabe wird dadurch gelöst, daß man Substratoberflächen mit einem Primer auf der Basis eines polymeren organischen Filmbildners beschichtet, der ein polymeres organisches Additiv aus der Gruppe der Polyester, Polyamide und Polyoxazoline mit einer Oberflächenspannung von 45-70 mN/m enthält.

Zur Aktivierung der mit einem solchen Primer versehenen Kunststoffoberfläche, können sowohl anorganische, ionogene und kolloidole Aktivierungssysteme (vgl. beispielsweise US-A 3 554 880, DE-A 2 503 317 und DE-A 2 335 497) als auch Aktivierungssysteme auf Basis der Komplexverbindungen von Palladium, Gold und Silber bzw. Platin eingesetzt werden (vgl. beispielsweise EP-A 0 081 129, DE-A 3 025 307, DE-A 2 116 389 und DE-A 2 451 217). Zur Durchführung des Verfahrens sind Systeme, die in der Anmeldung EP-A 0 081 129 und EP-A 0 131 195 beschrieben werden, besonders gut geeignet. Durch Einsatz dieser Aktivatoren wird eine gute Verankerung des Aktivators an der Substratoberfläche erzielt. Besonders geeignet für eine chemische Verankerung des Aktivators an der Substratoberfläche sind funktionelle Gruppen wie Carbonsäuregruppen, Carbonsäurehalogenidgruppen, Carbonsäureanhydridgruppen, Carbonestergruppen, Carbonamid- und Carbonimidgruppen, Aldehyd- und Ketongruppen, Ethergruppen, Sulfonamidgruppen, Sulfonsäuregruppen und Sulfonatgruppen, Sulfonsäurehalogenidgruppen, Sulfonsäureestergruppen, halogenhaltige heterocyclische Reste, wie Chlortriazinyl-, -pyrazinyl-, -pyridinyl-oder -chinoxalinylgruppen, aktivierte Doppelbindungen, wie bei Vinylsulfonsäure- oder Acrylsäurederivaten, Aminogruppen, Hydroxylgruppen, Isocyanatgruppen, Olefingruppe und Acetylengruppen sowie Mercaptogruppen und Epoxidgruppen, ferner höherkettige Alkyl- oder Alkenylreste ab $C_8$, insbesondere Olein-, Linolein-, Stearin- oder Palmitingruppen.

Es ist zweckmäßig, die die Adsorption hervorrufenden funktionellen Gruppen auf die jeweiligen Primeroberflächen abzustimmen.

Besonders geeignet für eine Verankerung des Aktivators an der Primeroberfläche durch Adsorption sind funktionelle Gruppen wie Carbonsäuregruppen und Carbonsäureanhydridgruppen.

Die für die Metallbindung erforderlichen Gruppen des organischen Teiles der metallorganischen Verbindung sind an sich bekannt. Es handelt sich z.B. um C-C- oder C-N- Doppel- und Dreifachbindungen und um Gruppen, die einen Chelat-Komplex ausbilden können, z.B. OH-, SH-, -CO- oder COOH-Gruppen.

Die organometallische Verbindung kann in dem organischen Lösungsmittel beispielsweise gelöst oder dispergiert sein, es kann sich auch um eine Anreibung der organometallischen Verbindungen mit dem Lösungsmittel handeln.

2

Wenn die organometallische Verbindung Liganden enthält, die eine chemische Fixierung auf der Substratoberfläche ermöglicht, kann eine Aktivierung auch aus wäßriger Phase möglich sein.

Das erfindungsgemäß neue Verfahren wird im allgemeinen folgendermaßen durchgeführt:

Eine metallorganische Verbindung von Elementen der 1. und 8. Nebengruppe des Periodensystems, insbesondere von Cu, Ag, Au, Pd und Pt mit zusätzlicher funktioneller Gruppe, wird in einem organischen Lösungsmittel gelöst. Selbstverständlich können auch Mischungen von Verbindungen eingesetzt werden. Die Konzentration an metallorganischer Verbindung soll zwischen 0,01 g und 10 g pro Liter betragen, kann aber in besonderen Fällen auch darunter oder darüber liegen.

Als organische Lösungsmittel sind besonders polare, protische und aprotische Lösungsmittel, wie Methylenchlorid, Chloroform, 1,1,1-Trichlorethan, Trichlorethylen, Perchlorethylen, Aceton, Methylethylketon, Butanol, Ethylenglykol und Tetrahydrofuran geeignet.

Selbstverständlich können auch Gemische obiger Lösungsmittel und Verschnitte mit anderen Lösungsmitteln, wie Benzin, Ligroin, Toluol, u.s.w. verwendet werden. Mit diesen Lösungen werden bei dem erfindungsgemäßen Verfahren die Oberflächen der zu metallisierenden Substrate benetzt, wobei die Einwirkungsdauer vorzugsweise 1 Sekunde bis 10 Minuten beträgt. Besonders geeignet sind dazu Verfahren wie das Eintauchen des Substrats in die Lösungen oder das Besprühen von Substratoberflächen mit den Aktivierungslösungen. Selbstverständlich ist es bei dem neuen Verfahren auch möglich, die Aktivierungslösungen durch Stempeln oder durch Druckverfahren aufzubringen.

Als Substrate für das erfindungsgemäße Verfahren eignen sich z.B. Formkörper aus Polyethylen, Polypropylen, ABS-Kunststoffen, Epoxyharzen, Polyester, Polyamid, Polyacrylnitril, Polyvinylhalogeniden und insbesondere Polycarbonaten, Polyphenylenoxiden und Polyimiden sowie aus deren Mischungen untereinander oder mit anderen Polymeren (z.B. Blends von ABS und Polycarbonat) und Pfropf- und Mischpolymerisaten.

Nach der Benetzung wird das organische Lösungsmittel entfernt. Dabei werden niedrig siedende Lösungsmittel bevorzugt durch Verdampfen, z.B. im Vakuum entfernt. Bei höher siedenden Lösungsmitteln sind andere Verfahren, wie Extraktion mit einem Lösungsmittel, in dem die organometallischen Verbindungen unlöslich sind, angebracht.

In diesem Zusammenhang sei ausdrücklich erwähnt, daß durch Einsatz von erfindungsgemäßen Primern eine quellende Haftbekeimung des Kunststoffes nicht erforderlich ist. Dadurch wird die Bildung von Spannungsrissen vermieden.

Die so vorbehandelten Oberflächen können anschließend durch Reduktion sensibilisiert werden. Dazu können bevorzugt die in der Galvanotechnik üblichen Reduktionsmittel, wie Hydrazinhydrat, Formaldehyd, Hypophosphit oder Borane verwendet werden. Natürlich sind auch andere Reduktionsmittel möglich. Bevorzugt wird die Reduktion in wäßriger Lösung durchgeführt. Es sind aber auch andere Lösungsmittel wie Alkohole, Ether, Kohlenwasserstoffe einsetzbar. Selbstverständlich können auch Suspensionen oder Aufschlämmungen der Reduktionsmittel verwendet werden.

Die so aktivierten Oberflächen können direkt zur stromlosen Metallisierung eingesetzt werden. Es kann aber auch erforderlich sein, die Oberflächen durch Spülen von Reduktionsmittelresten zu reinigen.

Eine ganz besonders bevorzugte Ausführungsform des erfindungsgemäßen Verfahrens besteht darin, daß die Reduktion im Metallisierungsbad gleich mit dem Reduktionsmittel der stromlosen Metallisierung durchgeführt wird. Diese Ausführung stellt eine Vereinfachung der stromlosen Metallisierung dar. Diese ganz einfach Ausführungsform besteht nur noch aus den drei Arbeitsgängen: Eintauchen des Substrats in die Lösung der organischen Verbindung, Verdampfen des Lösungsmittels und Eintauchen der so aktivierten Oberflächen in das Metallisierungsbad (Reduktion und Metallisierung).

Diese Ausführungsform ist ganz besonders für aminboranhaltige Nickelbäder oder formalinhaltige Kupferbäder geeignet.

Als in dem erfindungsgemäßen Verfahren einsetzbare Metallsierungsbäder kommen bevorzugt Bäder mit Nickelsalzen, Kobaltsalzen, Kupfersalzen, Gold- und Silbersalzen oder deren Gemische untereinander oder mit Eisensalzen in Betracht. Derartige Metallisierungsbäder sind in der Technik der stromlosen Metallisierung bekannt.

Das erfindungsgemäße Verfahren hat den Vorteil, auch ohne vorheriges oxidatives Ätzen und/oder Quellen bzw. Polymerketten aufweisende Lösungsmittelbehandlung der Substratoberfläche, daß es eine haftfeste Metallabscheidung durch die nachfolgende selektive stromlose Metallisierung nur mit Hilfe der Primeroberfläche ermöglicht.

Eine weiter ganz besonders bevorzugte Ausführungsform des erfindungsgemäßen Verfahrens besteht darin, daß die erwähnte Aktivator-Reduktion mittels Ultraschall-Bad mit bereits angegebenen Reduktionssysteme vorgenommen wird.

Mit Hilfe dieser Maßnahme wird eine selektive Metallabscheidung in nachfolgenden Metallisierungsbädern nur auf die Primeroberfläche mit 100 %iger Prozeß-Sicherheit erzielt. Selbstverständlich kann eine Ultraschallbehandlung vor bzw. nach dem Sensibilisierungsvorgang oder während der naßchemischen Metallabscheidung vorgenommen werden.

Als Filmbildner der Primerkomponente kommen sowohl bei Raumtemperatur trocknende oder vernetzende Lacksysteme als auch Einbrennlacke in Betracht.

Die bei Raumtemperatur zu verwendenden Lacksysteme sind z.B. Alkydharze, ungesättigte Polyesterharze, Polyurethanharze, Epoxidharze, modifizierte Fette und Öle, Polymerisate oder Copolymerisate auf Basis Vinylchlorid, Vinylether, Vinylester, Styrol, Acrylsäure, Acrylnitril oder Acrylester, Cellulosederivate. Als Einbrennlacke sind die bei höherer Temperatur vernetzenden Lacksysteme wie z.B. Polyurethane aus hydroxylgruppenhaltigen Polyethern, Polyestern oder Polyacrylaten und verkappten Polyisocyanaten, Melaminharze aus veretherten Melamin-Formaldehydharzen und hydroxylgruppenhaltigen Polyethern, Polyestern oder Polyacrylaten, Epoxidharze aus Polyepoxiden und Polycarbonsäuren, carboxylgruppenhaltigen Polyacrylaten und carboxylgruppenhaltigen Polyestern, Einbrennlacke aus Polyester, Polyesterimiden, Polyesteramidimiden, Polyamidimiden, Polyamiden, Polyhydantoinen und Polyparabansäuren geeignet. Diese Einbrennlacke können in der Regel sowohl als Pulver als auch aus Lösung appliziert werden.

Zur Durchführung des Verfahrens sind Filmbildner auf Basis von Polyurethansystemen besonders gut geeignet.

Zur Herstellung der Film- bzw. Matrixbildner werden erfindungsgemäß folgende Ausgangskomponenten verwendet:

1. Aliphatische, cycloaliphatische, araliphatische, aromatische und heterocyclische Polyisocyanate, wie sie z.B. von W. Siefken in Justus Liebigs Annalen der Chemie, 362, Seiten 75-136, beschrieben werden, beispielsweise solche der Formel

$$Q(NCO)_n$$

in der

$n$ = 2 bis 4, vorzugsweise 2 bis 3

und

Q einen aliphatischen Kohlenwasserstoffrest mit 2 bis 18, vorzugsweise 6 bis 10 C-Atomen,

einen cycloaliphatischen Kohlenwassertoffrest mit 4 bis 15, vorzugsweise 5 bis 10 C-Atomen,

einen aromatischen Kohlenwasserstoffrest mit 6 bis 15, vorzugsweise 6 bis 13 C-Atomen,

oder einen araliphatischen Kohlenwasserstoffrest mit 8 bis 15, vorzugsweise 8 bis 13 C-Atomen

bedeuten, z.B. solche Polyisocyanate, wie sie in der DE-OS 2 832 253, Seiten 10 bis 11, beschrieben werden. Besonders bevorzugt werden in der Regel die technisch leicht zugänglichen Polyisocyanate, z.B.: das 2,4- und 2,6-Toluylendiisocyanat, sowie beliebige Gemische dieser Isomeren ("TDI"); Polyphenylpolymethylen-polyisocyanate, wie sie durch Anilin-Formaldehyd-Kondensation und anschließende Phosgenierung hergestellt werden ("rohes MDI") und Carbodiimidgruppen, Urethangruppen, Allophanatgruppen, Isocyanuratgruppen, Harnstoffgruppen oder Biuretgruppen aufweisende Polyisocyanate ("modifizierte Polyisocyanate"), insbesondere solche modifizierten Polyisocyanate, die sich vom 2,4- und/oder 2,6-Toluylendiisocyanat bzw. vom 4,4'-und/oder 2,4'-Diphenylmethandiisocyanat ableiten.

2. Verbindungen mit mindestens zwei gegenüber Isocyanaten reaktionsfähigen Wasserstoffatomen von einem Molekulargewicht in der Regel von 400 bis 10 000. Hierunter versteht man neben Aminogruppen, Thiolgruppen oder Carboxylgruppen aufweisende Verbindungen, insbesondere zwei bis acht Hydroxylgruppen aufweisende Verbindungen, speziell solche vom Molekulargewicht 1000 bis 6000, vorzugsweise 2000 bis 6000, z.B. mindestens zwei, in der Regel zwei bis acht, vorzugsweise aber 2 bis 6, Hydroxylgruppen aufweisende Polycarbonate und Polyesteramide, wie sie für die Herstellung von homogenen und von zellförmigen Polyurethanen an sich bekannt sind und wie sie z.B. in der DE-OS 2 832 253, Seiten 11-18, beschrieben werden.

3. Gegebenenfalls Verbindungen mit mindestens zwei gegenüber Isocyanaten reaktionsfähigen Wasserstoffatomen und einem Molekülgewicht von 32 bis 399. Auch in diesem Fall versteht man hierunter Hydroxylgruppen und/oder Aminogruppen und/oder Thiolgruppen und/oder Carboxylgruppen aufweisende Verbindungen, vorzugsweise Hydroxylgruppen und/oder Aminogruppen aufweisende Verbindungen, die als Kettenverlängerungsmittel oder Vernetzungsmittel dienen. Diese Verbindungen weisen in der Regel 2 bis 8, vorzugsweise 2 bis 4, gegenüber Isocyanaten reaktionsfähige Wasserstoffatome auf. Beispiele hierfür werden in der DE-SO 2 832 253, Seiten 19-20, beschrieben.

4. Gegebenenfalls Wasser und/oder leicht flüchtige organische Substanzen als Treibmittel.

5. Gegebenenfalls Hilfs- und Zusatzmittel, wie

a) Katalystoren der an sich bekannten Art,

b) oberflächenaktive Zusatzstoffe, wie Emulgatoren und Stabilisatoren,

c) Reaktonsverzögerer, z.B. sauer reagierende Stoffe wie Salzsäure oder organische Säurehalogenide, ferner Zellregler - der an sich bekannten Art - wie Paraffine oder Fettalkohole oder Dimethylpolysiloxane sowie Pigmente oder
Farbstoffe und Flammschutzmittel der an sich bekannten Art, z.B. Tris-chlorethylphosphat, Trikresylphosphat, ferner Stabilisatoren gegen Alterungs- und Witterungseinflüsse, Weichmacher und fungistatisch und bakteriostatisch wirkende Substanzen.

Diese gegebenenfalls mitzuverwendenden Hilfs- und Zusatzstoffe werden beispielsweise in der DE-A 2 732 292, Seiten 21-24, beschrieben.

Die Primer enthalten weiterhin polymere organische Additive. Als Additiv kommen organische und/oder metallorganische polymere bzw. prepolymere Verbindungen mit Molmassen von 100-1 000 000, vorzugsweise 500-20 000 mit einer Oberflächenspannung im Bereich von 45-70 mN/m, vorzugsweise 45-60 mN/m, besonders bevorzugt 50-60 mN/m in Betracht.

Beispielhaft seien oligomere Polymethacrylsäure bzw. deren Ester wie Butyl-, Ethyl- und Methylester, Polyamide auf Basis von Adipinsäure, und Hexamethylendiamin, Polyethylenamine, -amide, Polyestertypen auf Basis von Adipinsäure, Phthalsäure, Butandiol, Trimethylolpropan und Polyacrylate wie Polyethyl- und Polybutylacrylat, Polyalkohole wie Polyvinylalkohol bzw. deren Mischungen untereinander genannt. Zur Durchführung des Verfahrens sind Polyestertypen des Viskositätsbereichs in cP 10 000-35 000 bei 20° C mit Hydroxylgehalt 5,5-0,15 % bzw. deren isocyanatmodifizierte Derivate ebenfalls gut geeignet. Ferner kommen Polyamine auf Basis beispielsweise von Ethylen-, Propylen- und Butylendiaminen zur Durchführung des Verfahrens in Betracht.

Zur Durchführung des Verfahrens kommen ebenso Polymere auf Basis von Oxazolinen wie Polyethyloxazolin, welches beispielsweise durch kationische Polymerisation aus Methyltosylat und Methyloxazolin hergestellt werden, in Betracht. Ferner sind Polymethyl-, Polypropyl- und Polybutyloxazoline zur Durchführung des Verfahrens hervorragend geeignet. Ihre Menge kann zwischen 1,0 und 85 Gew.-% bezogen auf die trocknende Lackmasse breit variiert werden. Wobei die 5-50 Gew.-% besonders bzw. die 10-35 Gew.-% ganz besonders zu bevorzugen sind.

Schließlich können die Primer auch Füllstoffe enthalten. Als anorganische Füllstoffe kommen Oxide der Elemente Mn, Ti, Mg, Al, Bi, Cu, Ni und Si, ferner Silikate, Bentonite, Talkum und Kreide in Betracht. Vorzugsweise jedoch werden zur Durchführung des Verfahrens solche anorganischen bzw. organischen Füllstoffe eingesetzt, deren Widerstand vorzugsweise zwischen $0,01\text{-}10^4 \; \Omega/cm$ liegt. Der besonders bevorzugte Füllstoff ist Leitruß.

Die Menge des Füllstoffes kann im Bereich von 0,5-50, vorzugsweise jedoch 0,5-10, besonders bevorzugt 0,5-7,5 Gew.-% bezogen auf trockene Lackmasse breit variiert werden.

Die Schichtdicke des Primers kann im Bereich vo 0,1-200 µm vorzugsweise jedoch im Bereich von 5-20 µm variiert werden. Sie kann nach den üblichen Methoden wie Bedrucken, Bestempeln und Besprühen auf die Kunststoffoberflächen aufgebracht werden. Hierbei sei ausdrücklich darauf hingewiesen, daß der Primer frei von zur Aktivierung geeigneten Metallen wie Pd, Au, Ag, Pt, Cu, Ni und Ru sowie deren Salze bzw. Komplexverbindungen, ist.

Somit ermöglicht das neue Verfahren eine materialschonende und umweltfreundliche bzw. kostengünstige Metallabscheidung auf polymere Werktoffoberflächen. Nach dem neuen Verfahren metallisierte Werkstoffe zeichnen sich durch ihre hervorragende Abschirmung gegenüber den elektromagnetischen Wellen aus. Diese Werkstoffe finden Verwendung im Elektro-, Automobil-, Elektronik- und Haushaltsbereich.

Bei den in nachfolgenden Beispielen genannten Produktnamen handelt es sich zum Teil um eingetragene Warenzeichen.

Beispiel 1

Eine 100 x 100 mm große Bayblendplatte des Tpys T 45 MN (polycarbonathaltiges ABS) der Fa. Bayer AG, 5090 Leverkusen 1, wird mit einem 10 µm starken Primer, bestehend aus 53,7 Gew.-Teile Desmolac 4125 (Polyurethanharz), 198 Gew.-Teile Lösemittelgemisch, bestehend aus Toluol, Diacetonalkohol und Isopropanol (1:1:1); 14,7 Gew.-Teile Titandioxid; 5,4 Teile Talkum; 5,4 Gew.-Teile Kreide des Tpys Millicarb der Fa. Omya, 5000 Köln, 7,2 Gew.-Teile Ruß des Typs Efwekoschwarz NC 18/2, 20 %ig in Butylacetat der Fa. Degussa AG, Frankfurt/Main; 6,6 Gew.-Teile Polyester mit 4,3 % OH-Gruppen des Typs Desmophen 670 mit einer Oberflächenspannung > 45 mN/m, 20 %ige Lösung im MEK (methylethylketon) und DAA (Diacetonalkohol) (1:1); 9 Gew.-Teile Schwebemittel auf Silikatbasis, 10 %iger Aufschluß in Xylol der Fa. Kronos Titan GmbH, 5090 Leverkusen 1, einseitig versehen, bei 80°C im Verlaufe von 45 Minuten getrocknet.

Anschließend wird diese Platte in einer Aktivierungslösung, bestehend aus

```
    0,7  g  Mesityloxidpalladiumchlorid
 1000    ml Isopropanol
```

im Verlaufe von 5 Minuten aktiviert, 5 Minuten in einem Ultraschallbad, bestehend aus 10 g Dimethylaminboran, 1,0 g NaOH, bei 30°C mittels Ultraschall behandelt und anschließend bei RT in einem chemischen Verkupferungsbad der Fa. Shipley AG, im Verlaufe von 30 Minuten verkupfert, mit $H_2O$ destilliert, gewaschen und anschließend bei 80° C 30 Minuten getempert.

Man bekommt eine einseitig metallisierte Platte, Diese Platte ist gegenüber den elektromagnetischen Wellen abschirmend. Da eine Metallabscheidung trotz einer Tauchaktivierung bzw. Tauchmetallisierung nur auf Primeroberfläche stattfindet, ist eine zusätzliche Isolierung durch eine herkömmliche Lackierung nicht erforderlich. Die Metallauflage haftet an der Primeroberfläche so gut, daß sie sowohl den Tesafilmtest nach DIN 53 151, als auch den Wärmeschocktest mit sehr gut besteht.

Ferner weist die Metallauflage nach DIN 53 494 eine Abzugsfestigkeit von 20 N/25 mm (20 N/inch) auf.

Beispiel 2

Eine 100 x 100 mm große ABS-Platte des Typs PM 3 C der Fa. Bayer AG, wird nach Beispiel 1 einseitig mit einer Primerauflage versehen und dann in einem Aktivierungsbad, besthend aus

```
    0,7  g  Bisbenzonitrilpalladiumdichlorid
 1000    ml H2O dest.
```

aktiviert und in einem Bad, bestehend aus

```
 1000 ml Ethanol
    9 g  Dimethylaminboran
    2 g  LiOH
```

sensibilisiert und anschließend bei 30° C im Verlaufe von 10 Minuten im $H_2O$ dest. einer Ultraschall-Behandlung unterworfen.

Anschließend wird diese Platte im Verlaufe von 45 Minuten in einem chemischen Vernickelungsbad der Fa. Blasberg AG, Solingen, vernickelt.

Man bekommt eine gegenüber den elektromagnetischen Wellen gut abgeschirmte Kunststoffplatte mit sehr guter Metallhaftung. Die Metallauflage besteht den Gitterschnitt und den Tesafilmtest. Die Abzugsfestigkeit der Metallauflage beträgt 15 N/25 mm (15 N/inch).

Beispiel 3

Eine PPO-(Polyphenylenoxid)-PS(Polystyrol)-Platte mit dem Handelsnamen Nonyl der Fa. Generel Electric wird mit einem Primer, bestehend aus

```
   53,7  Gew.-Teile  Desmolac 4125
  200    Gew.-Teile  Lösemittelgemisch, bestehend aus
                      Toluol, Diacetonalkohol und Iso-
                      propanol (1:1:1)
   15    Gew.-Teile  Titandioxid
    6    Gew.-Teile  Talkum
```

```
8      Gew.-Teile  Ruß des Typs Efwekoschwarz NC
                   18/2 20 %ig in Butylacetat der
                   Fa. Degussa AG
7      Gew.-Teile  PEOX (Poly-2-ethyl-2-oxazolin
                   der Fa. Dow, 20 %ige Lösung in
                   MEK
8      Gew.-Teile  Schwebemittel auf Silikatbasis
                   10 %iger Aufschluß in Xylol der
                   Fa. Kronos Titan GmbH,
                   5090 Leverkusen 1, einseitig
                   versehen, bei 80°C im Verlaufe
                   von 45 Minuten getrocknet.
```

Anschließend wird diese Platte in einer Aktivierungslösung, bestehend aus

```
0,8    Gew.-Teile   1,2-Butadienpalladiumdichlorid
1000   Gew.-Teile   1,1,1-Trichlorethan
```

im Verlaufe von 5 Minuten aktiviert, an der Luft getrocknet, 7,5 Minuten bei 40° C in einem Bad, bestehend aus

```
7,0    Gew.-Teile   Dimethylaminboran
0,5    Gew.-Teile   NaOH fest.
1000   Gew.-Teile   H₂O dest.
```

sensibilisiert anschließend die Platte mit $H_2O$ dest, einer Ultraschall-Behandlung ausgesetzt.

Die so aktiviert und sensibilisierte Platte wird in einem chemischen Verkupferungsbad der Fa. Schering AG, 1000 Berlin, im Verlaufe von 45 Minuten mit einer 1,0 µm starken Cu-Auflage versehen.

Man bekommt eine einseitig metallisierte Kunststoff-Platte mit einer sehr guten Metallhaftung.

Diese Platte ist gegenüber den elektromagnetischen Wellen gut abschirmend.

### Beispiel 4

Eine Bayblendplatte (65 % polycarbonathaltiges ABS der Fa. Bayer AG) wird nach Beispiel 3 mit einer Primerauflage versehen und dann nach Beispiel 1 aktiviert, einer Ultraschall-Behandlung ausgesetzt bzw. mit einer Metallauflage versehen. Man bekommt einer gegenüber den elektromagnetischen Wellen gut abgeschirmte Platte mit einer guten Metallhaftung.

### Beispiel 5

Eine 100 x 100 mm große ABS-Platte wird mit einem 15 µm starken Primer, bestehend aus einem 50 Gew.-Teile 2K-PU-System mit Polyolkomponente:

88,7 Gew.-Teile      eines Polyesterpolyols des Molekulargewichts 2000 aus Adipinsäure, Ethylenglykol und 1,4-
Dihydroxybutan (Molverhältnis der
Diole 70:30)

8,0  Gew.-Teile   Ethylenglykol
0,5  Gew.-Teile   Wasser
0,5  Gew.-Teile   Triethylendiamin
0,55 Gew.-Teile   eines handelsüblichen Polysiloxanstabilisators (Stabilisator D 193 der Fa. Dow Corning)

Polyisocyanat-Komponente:

90,0  Gew.-Teile   eines NCO-Prepolymeren aus
65     Gew.-Teile   4,4'-Diisocyanatdiphenylmethan
und
38     Gew.-Teile   des in Polyolkomponente verwendeten Polyesterdiols
250    Gew.-Teile   Lösemittelgemisch, betehend aus
Toluol, DAA (Diacetonalkohol) und
Isopropanol (1:1:1)
15     Gew.-Teile   Kreide
8      Gew.-Teile   Ruß des Typs Efwekoschwarz NC
18/2, 20 %ig in Butylacetat der
Fa. Degussa AG
10     Gew.-Teile   Polyester mit 3,2 % OH-Gruppen
der Fa. Bayer AG, mit einer Oberflächenspannung > 48 mN/m,
20 %ige Lösung im MEK und DAA
(1:1)

mittels Robotor einseitig beschichtet und dann nach Beispiel 1 verkupfert, bei 70°C 20 Minuten getempert. Man bekommt eine gegenüber den elektromagnetischen Wellen abgeschirmte Kunststoffplatte mit guter Metallhaftung. Die Haftung der Metallauflage beträgt 20 N/inch.

Beispiel 6

Eine 100 x 100 mm große Polyvinylchlorid-Platte wird nach Beispiel 5 mit einer 10 µim starken Primerauflage versehen und dann noch mit einem Aktivator, bestehend aus

```
0,8 g    Pentandionpalladium-II-chlorid
900  ml  H₂O dest.
```

aktiviert bzw. nach Beispiel 1 sensibilisiert und metallisiert.

Man bekommt eine gegenüber den elektromagnetischen Wellen gut abgeschirmte Platte mit einer sehr guten Metallhaftung.

Sie besteht den Wärmeschocktest (Lagerung bei 80° C 2 Stunden und anschließend schockartiges Abkühlen auf -30° C), den Gitterschnitt-Test.

Die Abzugsfestigkeit der Metallauflage beträgt 18 N/25 mm (18 N/inch).

## Patentansprüche

1. Verfahren zum Abscheiden von haftfesten Metallauflagen auf Substratoberflächen durch Aktivieren, gegebenenfalls Sensibilisieren und anschließende stromlose naßchemische Metallisierung, dadurch gekennzeichnet, daß man die Oberflächen mit einem Primer auf der Basis eines polymeren organischen Filmbildners, der ein polymeres organisches Additiv aus der Gruppe der Polyester, Polyamide und Polyoxazoline mit einer Oberfächenspannung von 45-70 mN/m enthält, vorbehandelt.

2. Verfahren nach Anspruch 1, dadurch gekennzeichnet, daß die filmbildende Komponente des Primers aus einem Polyurethan besteht.

3. Verfahren nach Anspruch 1, dadurch gekennzeichnet, daß die Aktivierung mit Komplexverbindungen der Elemente Cu, Au, Ag, Pt, Pd oder Ru vorgenommen wird.

4. Verfahren nach Anspruch 1, dadurch gekennzeichnet, daß nach der Aktivierung eine Behandlung mit Ultraschall vorgenommen wird.

5. Verfahren nach Anspruch 1, dadurch gekennzeichnet, daß der Primer einen Füllstoff enthält.

6. Verfahren nach Anspruch 1 oder 5, dadurch gekennzeichnet, daß der Primer als Füllstoff Silikate und/oder Leitruße enthält.

7. Verwendung des Verfahrens nach Anspruch 1 zur Herstellung von metallisierten Formkörpern für die Abschirmung elektromagnetischer Wellen.

## Claims

1. Process for depositing strongly adhering metallic coatings on substrate surfaces by activating, sensitizing if desired, and subsequent currentless metallizing by wet chemical methods, characterized in that the surfaces are pretreated with a primer based on a polymeric organic film former, which contains a polymeric organic additive from the group consisting of the polyesters, polyamides and polyoxazolines and having a surface tension of 45-70 mN/m.

2. Process according to Claim 1, characterized in that the film forming component of the primer comprises a polyurethane.

3. Process according to Claim 1, characterized in that the activation is carried out using complexes of the elements Cu, Au, Ag, Pt, Pd or Ru.

4. Process according to Claim 1, characterized in that an ultrasound treatment is carried out after the activation.

5. Process according to Claim 1, characterized in that the primer contains a filler.

6. Process according to Claim 1 or 5, characterized in that the primer contains silicates and/or conductive carbon blacks as filler.

7. Use of the process according to Claim 1 for producing metallized mouldings for shielding from electromagnetic waves.

## Revendications

1. Procédé pour déposer des couches métalliques adhérant fortement sur des surfaces de substrats par activation, le cas échéant sensibilisation puis métallisation chimique par voie humide sans passage de courant, caractérisé en ce qu'on traite préalablement les surfaces avec un apprêt à base d'un produit organique filmogène polymérique qui contient un additif organique polymérique du groupe des polyesters, des polyamides et des polyoxazolines ayant une tension superficielle de 45 à 70 mN/m.

2. Procédé suivant la revendication 1, caractérisé en ce que le composant filmogène de l'apprêt est constitué d'un polyuréthanne.

3. Procédé suivant la revendication 1, caractérisé en ce que l'activation est effectuée avec des composés complexes des éléments Cu, Au, Ag, Pt, Pd ou Ru.

4. Procédé suivant la revendication 1, caractérisé en ce qu'on effectue après l'activation un traitement aux ultrasons.

5. Procédé suivant la revendication 1, caractérisé en ce que l'apprêt contient une charge.

6. Procédé suivant la revendication 1 ou 5, caractérisé en ce que l'apprêt contient comme charge des silicates et/ou des noirs conducteurs.

7. Utilisation du procédé suivant la revendication 1 pour la production de pièces moulées métallisées pour la protection vis-à-vis d'ondes électromagnétiques.